# EUROPÄISCHE PATENTSCHRIFT

(11) **EP 1 423 717 B1**
(45) Veröffentlichungstag und Bekanntmachung des Hinweises auf die Patenterteilung: **07.12.2005**
(21) Anmeldenummer: 02762467.5
(22) Anmeldetag: 28.08.2002
(51) Int. Cl.: G01R 31/00, B60R 16/02, G01R 31/02

(54) **VERFAHREN UND VORRICHTUNG ZUR ON-BOARD BORDNETZDIAGNOSE EINES KRAFTFAHRZEUGBORDNETZES**
METHOD AND DEVICE FOR THE DIAGNOSIS OF AN ELECTRIC SYSTEM IN A MOTOR VEHICLE ELECTRIC SYSTEM
PROCEDE ET DISPOSITIF POUR REALISER A BORD UN DIAGNOSTIC D'UN RESEAU DE BORD D'UNE AUTOMOBILE

(30) Priorität: 30.08.2001 DE 10142085
(43) Veröffentlichungstag der Anmeldung: 02.06.2004
(73) Patentinhaber: Volkswagen AG, 38436 Wolfsburg (DE)
(72) Erfinder: BROSIG, Stefan, 29386 Hankenbüttel (DE); MANZ, Holger, 38173 Sickte (DE); WAHNSCHAFFE, Nikolaus, 38444 Wolfsburg/Hattorf (DE)
(74) Vertreter: Zucker, Volker
(86) Internationale Anmeldenummer: PCT/EP2002/009607
(87) Internationale Veröffentlichungsnummer: WO 2003/021280

(56) Entgegenhaltungen:
- EP-A- 0 710 931
- DE-A- 3 842 921
- DE-C- 19 546 553
- DE-C- 19 845 562

## Beschreibung

Die Erfindung betrifft ein Verfahren und eine Vorrichtung zur on-board Bordnetzdiagnose eines Kraftfahrzeuges während des Fahrbetriebes.

Aufgrund der Zunahme von elektrischen Verbrauchern in einem Kraftfahrzeugbordnetz, wobei diese teilweise sicherheitsrelevant sind, ist es notwendig, den Bordnetzzustand on-board kontinuierlich während des Fahrbetriebes zu überwachen und gegebenenfalls geeignete Gegenmaßnahmen einzuleiten.

Die meisten bekannten Verfahren zur Bordnetzdiagnose vergleichen einen aktuellen Istwert der Bordnetzspannung mit einem vorgebbaren Sollwert, wobei bei einer signifikanten Abweichung die Leerlaufdrehzahl eines Generators erhöht und/oder Komfortverbraucher nach Prioritäten gestuft abgeschaltet werden, bis sich der Bordnetzzustand wieder gebessert hat.

Aus der DE 198 45 562 C1 Oberbegriff von Anspruch 1 ist ein Verfahren zur Ermittlung des Bordnetzzustandes eines Kraftfahrzeuges bekannt, bei dem zur Beurteilung des Bordnetzzustandes geprüft wird, ob die im Bordnetz vorhandene Spannung der Fahrzeugbatterie einen kritischen Grenzwert erreicht, der einen kritischen Bordnetzzustand repräsentiert, wobei ein über einen längeren Zeitraum gemittelter Spannungswert oder ein aktueller Spannungswert, aus dem kurzzeitige Spannungsänderungen herausgefiltert sind, als Batteriespannung ausgewertet wird, wobei der aktuelle Spannungswert zur Beurteilung des Bordnetzzustandes nur dann herangezogen wird, wenn kein kurzzeitiger Hochstromverbraucher eingeschaltet ist und/oder wenn bei eingeschaltetem kurzzeitigen Hochstromverbraucher der aktuelle Spannungswert größer ist als der über einen längeren Zeitraum gemittelte Spannungswert.

Aus der DE 195 46 553 C1 ist ein Verfahren zum Prüfen von elektrischen Verbrauchern in einem Fahrzeug-Bordnetz bekannt, bei dem selektiv die von einer Fahrzeugbatterie gespeisten Verbraucher ein- und ausgeschaltet werden, wobei jeweils die verbraucherspezifische Stromaufnahme im eingeschalteten Zustand ermittelt und bewertet wird, wobei zur Ermittlung der Stromaufnahme die Batteriespannung unmittelbar vor und kurz nach Abschalten des zuvor eingeschalteten Verbrauchers, nach Abklingen eines Schaltimpulses gemessen und aus der Spannungsdifferenz die verbraucherspezifische Stromaufnahme ermittelt wird.

Aus der EP 0 710 931 A2 ist ein Verfahren zur Überprüfung der von einem Fahrzeugdatenerfassungsgerät zu registrierenden, die Betätigung eines Fahrzeugaggregates anzeigenden Meldung, wobei das Fahrzeugdatenerfassungsgerät und das Fahrzeugaggregat, dessen seine Betätigung anzeigende Meldung zu registrieren ist, an dasselbe Bordnetz des Fahrzeugs angeschlossen sind, wobei vom Fahrzeugdatenerfassungsgerät zum einen das Auftreten und/oder das Wegfallen der Meldung, welche die Betätigung eines Fahrzeugaggregates anzeigt, als Signal erfasst wird, zum anderen auch das Auftreten von Spannungsspitzen und/oder von Pegeländerungen im Bordnetz des Fahrzeugs als weiteres Signal erfasst werden, wobei die zu registrierende Information aus einem Vergleich der Ereigniszeitpunkte der beiden erfassten Signale gewonnen wird.

Aus der DE 38 42 921 A1 ist eine Schaltungsanordnung zur Stromüberwachung elektrischer Verbraucher bekannt, die in ihrer Stromzuführung ein Strommessglied aufweisen, dessen stromabhängige Messspannung einer Auswerteschaltung mit einem Mikrorechner zugeführt wird, der über Steuerausgänge die Schaltmittel für das Ein- und Ausschalten der zu überwachenden Verbraucher steuert, wobei die Auswerteschaltung bei einem abnormalen Verbraucherstrom durch Vergleich mit vorgegebenen Stromgrenzwerten ein Störsignal erzeugt, wobei das stromabhängig veränderbare Potential des Strommessgliedes auf einen Eingang eines Komparators gelegt ist, dessen anderer Eingang am Ausgang eines Digital-Analog-Wandlers angeschlossen ist, der eingangsseitig über eine Busleitung mit einem Ausgang des Mikrorechners verbunden ist, an dem jeweils mit dem Einschalten eines der zu überwachenden Verbraucher ein diesem zugeordneter, zeitlich abgestuft gesteuerter Grenzwert auftritt und bei Abweichung des augenblicklichen Verbraucherstromes vom augenblicklichen Grenzwert um einen vorgegebenen Betrag am Ausgang des Komparators das Störsignal auftritt.

Der Erfindung liegt daher das technische Problem zugrunde, ein Verfahren und eine Vorrichtung zur Bordnetzdiagnose eines Kraftfahrzeuges zu schaffen, die die Diagnose des Bordnetzzustandes weiter verbessem.

Die Lösung des technischen Problems ergibt sich durch die Gegenstände mit den Merkmalen der Patentansprüche 1 und 8. Weitere vorteilhafte Ausgestaltungen der Erfindung ergeben sich aus den Unteransprüchen.

Hierzu wird die Welligkeit der Bordnetzspannung erfasst und ausgewertet, da aus der Welligkeit der Bordnetzspannung Rückschlüsse auf das Vorhandensein bzw. die Funktionalität der Batterie möglich ist. Die Grundidee dabei ist, dass normalerweise die wellige Generatorspannung durch die Batterie geglättet ist. Ist hingegen die Batterie defekt oder steht aufgrund eines Kabelabrisses nicht mehr zur Verfügung, so muss sich dies in der Welligkeit nicht aber unbedingt im Spannungswert der Bordnetzspannung bemerkbar machen. Dabei wird bei Erfassung eines bordnetzkritischen Zustandes ein Lüfter, vorzugsweise der Verbrennungsmotorlüfter zugeschaltet, der bei einem Spannungseinbruch generatorisch wirkend mechanisch gespeicherte Leistung elektrisch in das Bordnetz zurückspeist.

In einer bevorzugten Ausführungsform wird hierzu der Bordnetzspannung ein oberer und unterer Grenzwert zugeordnet und die Anzahl der Über- und/oder Unterschreitungen der Grenzwerte pro Zeiteinheit ermittelt. Hierdurch wird verhindert, dass singuläre Schaltereignisse oder Steuerungen, die zu Bordnetzschwankungen führen, als Batteriedefekt eingeordnet werden. Aufgrund der beiden Grenzwerte wird somit ein Toleranzfenster definiert, wobei die Anzahl der Abweichungen aus dem Toleranzfenster ein Maß für die Welligkeit ist.

In einer alternativen Ausführungsform wird hingegen kontinuierlich nur das Über- oder Unterschreiten des Grenzwertes festgestellt oder aber kontinuierlich der absolute Wert der Abweichung erfasst und mit einem Grenzwert verglichen. Diese Abweichung wird dann als Batteriedefekt diagnostiziert.

In einem weiteren bevorzugten Verfahrensschritt wird dann der Gradient aus dem Mittelwert der Abweichung erfasst und ausgewertet. Hierdurch kann eine Aussage gemacht werden, ob die Abweichung auf einem Schaltvorgang beruht. Dabei gilt die Überlegung, dass sich Schaltvorgänge in einem steilen Gradienten bemerkbar machen, wohingegen der Gradient bei einem Batteriekabelrelais bzw. Batteriedefekt eher gering ist. Somit liefert der Gradient aus dem Mittelwert der Abweichung ein Überprüfungskriterium für die Diagnose Batteriedefekt.

In einem weiteren Verfahrensschritt wird die Bordnetzspannung tiefpassgefiltert und der Offset zu einer intakten Bordnetzspannung bestimmt. Hieraus lässt sich bestimmen, ob das Bordnetz beispielsweise aufgrund einer Vielzahl aktiver Verbraucher stark belastet ist oder nicht. Bei einem größeren Offset wird davon ausgegangen, dass viele Verbraucher aktiv sind, deren Leistungsanforderung zu Spannungsschwankungen führen kann. Somit liefert der Offset der geglätteten Bordnetzspannung zu einer intakten Bordnetzspannung ein weiteres Überprüfungskriterium für die Diagnose Batteriedefekt.

Diese drei Verfahrensschritte können nun parallel durchgeführt werden, wobei die Einzelergebnisse gewichtet zu einer Gesamtaussage zusammengefasst werden. Dabei kann auch auf die bekannte Fuzzy-Logik zurückgegriffen werden.

Alternativ können die einzelnen Verfahrensschritte auch seriell durchgeführt werden, wobei der nächste Verfahrensschritt nur durchgeführt wird, wenn der vorangegangene Verfahrensschritt negativ war.

Die Erfindung wird nachfolgend anhand eines bevorzugten Ausführungsbeispieles näher erläutert. Die Fig. zeigen:
- Fig. 1: einen schematischen Spannungsverlauf eines intakten Bordnetzes mit Einschaltspitzen,
- Fig. 2: einen schematischen Spannungsverlauf eines Bordnetzes mit defekter Batterie,
- Fig. 3: einen ermittelten Gradienten aus dem Mittelwert einer Abweichung gemäß Fig. 1,
- Fig. 4: einen ermittelten Gradienten aus dem Mittelwert einer Abweichung gemäß Fig. 2,
- Fig. 5: eine Darstellung eines Offsets einer aktuellen Bordnetzspannung zu einer intakten Bordnetzspannung bei geringerer Bordnetzbelastung und
- Fig. 6: eine Darstellung eines Offsets einer aktuellen Bordnetzspannung zu einer intakten Bordnetzspannung bei starker Bordnetzbelastung.

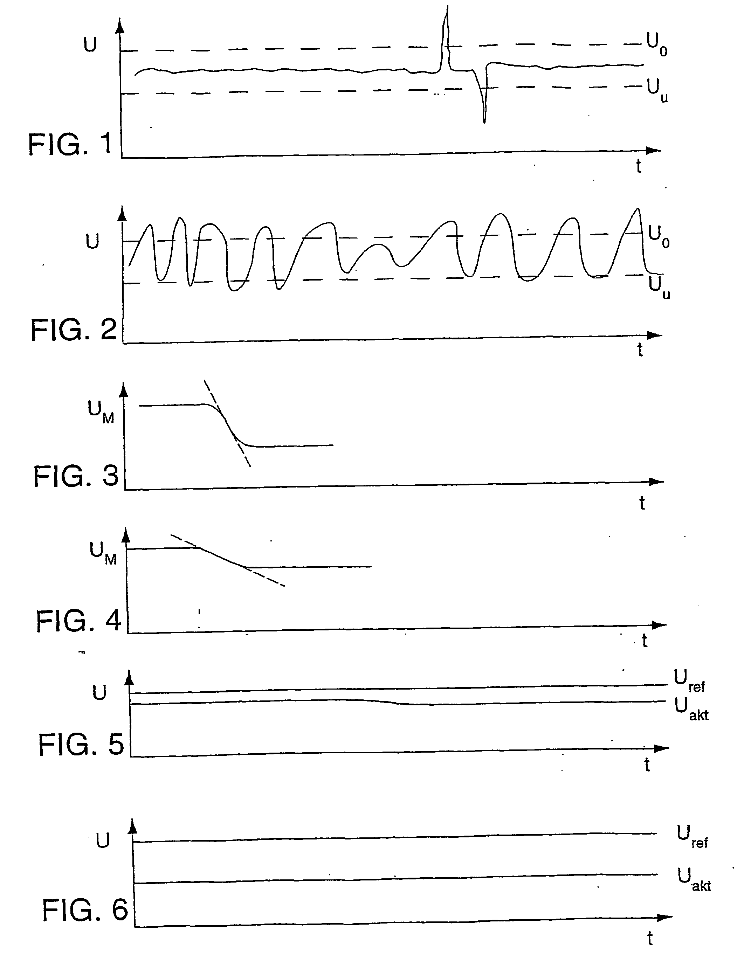

In der Fig. 1 ist ein schematischer Spannungsverlauf eines intakten Bordnetzes mit Einschaltspitzen beispielsweise aufgrund von induktiven Lasten dargestellt. Der Bordnetzspannung U ist dabei ein oberer Grenzwert Uₒ und ein unterer Grenzwert Uᵤ zugeordnet. Die Bordnetzspannung U weist eine ganz geringe Welligkeit auf, so dass die Bordnetzspannung U mit Ausnahme der Schaltspitzen stets zwischen den beiden Grenzwerten Uₒ und Uᵤ verbleibt. Diese minimale Welligkeit ist ein typisches Anzeichen für eine intakte Batterie, die die Welligkeit der Generatorspannung glättet. Im Gegensatz hierzu weist die Bordnetzspannung U gemäß Fig. 2 eine starke Welligkeit auf, was ein typisches Anzeichen für eine defekte Batterie ist. Wie erkennbar, ist das einfache Über- bzw. Unterschreiten des oberen Grenzwertes Uₒ bzw. des unteren Grenzwertes Uᵤ alleine kein geeignetes Mittel zur Erfassung eines Batteriedefektes. Allerdings kann aufgrund der Häufigkeit, also der Anzahl der Über- bzw. Unterschreitungen der oberen bzw. unteren Grenzwerte auf das Maß der Welligkeit geschlossen werden. Hierzu kann beispielsweise ein Zähler verwendet werden, der jeweils beim Überschreiten bzw. Unterschreiten eins hochgesetzt wird.

Anstelle der oberen und unteren Grenzwerte kann auch der absolute Spannungshub erfasst werden und mit einem Grenzwert verglichen werden. Hierdurch ergibt sich eine Unabhängigkeit vom Niveau des Gleichspannungsanteils der Bordnetzspannung U.

Alternativ zu dem Zähler kann auch die Bordnetzspannung kontinuierlich überwacht werden, wobei die Erfassung der Welligkeit über einen Min-Max-Vergleich der erfassten Bordnetzspannung erfolgt. Überschreitet die Welligkeit einen vorgegebenen Grenzwert, so wird die Diagnose Batteriedefekt gestellt.

Zur Reduzierung der Fehldiagnosen wird nun die Bordnetzspannung im Bereich der Welligkeit näher untersucht, um so Rückschlüsse über die Ursache der Welligkeit zu erhalten.

Eine Möglichkeit besteht darin, den Gradienten aus dem Mittelwert UM der Abweichung zu bestimmen, was für zwei Schwankungen in den Fig. 3 und 4 dargestellt ist. Ist der Gradient sehr groß, wie in Fig. 3 dargestellt, so ist die Schwankung aller Wahrscheinlichkeit nach auf einen Einschaltvorgang zurückzuführen, wohingegen ein kleiner Gradient eher für einen Batteriedefekt spricht.

Eine weitere Möglichkeit der näheren Untersuchung der Schwankung ist die Ermittlung des Offsets der aktuellen Bordnetzspannung Uₐₖₜ zu einer intakten Bordnetzreferenzspannung U_{ref}. Hierzu wird die Bordnetzspannung U tiefpassgefiltert, so dass hochfrequente Schwankungen herausgefiltert werden. Die Differenz U_{ref}-Uₐₖₜ gibt somit den Gleichspannungs-Offset wieder, wobei anhand der Größe des Offsets auf die Bordnetzbelastung zurückgeschlossen werden kann. So spricht ein geringer Offset, wie in Fig. 5 dargestellt, für eine geringe Bordnetzbelastung und ein hoher Offset, wie in Fig. 6 dargestellt, für eine starke Bordnetzbelastung.

Wird nun eine Welligkeit der Bordnetzspannung erfasst, wobei der Gradient niedrig und der Offset gering sind, so spricht dies für eine korrekte Diagnose defekte Batterie, so dass entsprechende Gegenmaßnahmen wie beispielsweise Zuschaltung eines Lüfters und/oder Informierung des Fahrers eingeleitet werden sollten. Selbstverständlich können auch die Überprüfungsschritte Gradient und Offset-Bestimmung zusätzlich bei der Ausführungsform mit dem Zähler eingesetzt werden.

## Patentansprüche

1. Verfahren zur on-board Bordnetzdiagnose eines Kraftfahrzeugbordnetzes während des Fahrbetriebes des Kraftfahrzeuges, wobei die Bordnetzspannung erfasst und ausgewertet wird,
**dadurch gekennzeichnet, dass**
die Welligkeit der Bordnetzspannung erfasst wird, wobei bei Erfassung eines bordnetzkritischen Zustandes ein Lüfter eingeschaltet wird, der bei einem Spannungseinbruch generatorisch wirkend mechanisch gespeicherte Energie in das Bordnetz zurüchspeist.

2. Verfahren nach Anspruch 1, **dadurch gekennzeichnet, dass** der Bordnetzspannung ein oberer und unterer Grenzwert (Uₒ, Uᵤ) zugeordnet wird und die Anzahl der Über- und/oder Unterschreitungen der Grenzwerte pro Zeiteinheit ermittelt werden.

3. Verfahren nach Anspruch 1, **dadurch gekennzeichnet, dass** eine absolute oder relative Schwangungsbreite der Bordnetzspannung erfasst wird.

4. Verfahren nach Anspruch 2 oder 3, **dadurch gekennzeichnet, dass** der Gradient aus dem Mittelwert der Abweichung erfasst wird.

5. Verfahren nach einem der Ansprüche 2 bis 4, **dadurch gekennzeichnet, dass** die Bordnetzspannung tiefpassgefiltert wird und der Offset zu einer intakten Bordnetzspannung bestimmt wird.

6. Verfahren nach Anspruch 4 oder 5, **dadurch gekennzeichnet, dass** die Verfahrensschritte parallel durchgeführt werden und die Einzelergebnisse gewichtet zusammengefasst werden.

7. Verfahren nach Anspruch 4 oder 5, **dadurch gekennzeichnet, dass** die Verfahrensschritte nacheinander durchgeführt werden, wobei der nächste Verfahrensschritt nur durchgeführt wird, falls der vorangegangene Verfahrensschritt negativ war.

8. Vorrichtung zur on-board Bordnetzdiagnose eines Kraftfahrzeugbordnetzes während des Fahrbetriebes des Kraftfahrzeuges, umfassend eine Einrichtung zur Erfassung und Auswertung der Bordnetzspannung,
**dadurch gekennzeichnet, dass**
über die Einrichtung die Welligkeit der Bordnetzspannung ermittelbar ist und der Einrichtung ein Lüfter zugeordnet ist, der in Abhängigkeit der Bordnetzdiagnose zuschaltbar ist.

9. Vorrichtung nach Anspruch 8, **dadurch gekennzeichnet, dass** die Schwänkungsbreite der Bordnetzspannung erfassbar ist.

10. Vorrichtung nach Anspruch 9, **dadurch gekennzeichnet, dass**
die Schwangungsbreite der Bordnetzspannung, der Gradient aus dem Mittelwert der Abweichung und/oder ein absoluter Offset der tiefpassgefilterten Bordnetzspannung bestimmbar sind und in der Einrichtung zu einem Ergebnis zusammenfassbar sind.

11. Vorrichtung nach Anspruch 8, **dadurch gekennzeichnet, dass**
die Anzahl der Über- oder Unterschreitungen der Bordnetzspannungen eines zuordenbaren oberen und unteren Grenzwertes pro Zeiteinheit erfassbar ist.

## Claims

1. Method for the on-board diagnosis of a motor-vehicle electrical system while the motor vehicle is being driven, in which the voltage of the vehicle electrical system is detected and evaluated,
**characterized in that**
the ripple of the voltage of the vehicle electrical system is detected, with a fan, which acts in the manner of a generator to feed mechanically stored power back to the vehicle electrical system in the event of a voltage dip, being switched on when a critical state of the vehicle electrical system is detected.

2. Method according to Claim 1, **characterized in that** the voltage of the vehicle electrical system has an associated upper limit value (Uₒ) and an associated lower limit value (Uᵤ), and the number of times the voltage exceeds and/or falls below the limit values per unit time is determined.

3. Method according to Claim 1, **characterized in that** an absolute or relative fluctuation range of the voltage of the vehicle electrical system is detected.

4. Method according to Claim 2 or 3, **characterized in that** the gradient from the mean value of the deviation is detected.

5. Method according to one of Claims 2 to 4,
**characterized in that** the voltage of the vehicle electrical system is low-pass-filtered and the offset to an intact voltage of the vehicle electrical system is determined.

6. Method according to Claim 4 or 5, **characterized in that** the method steps are carried out in parallel and the individual results are combined in a weighted fashion.

7. Method according to Claim 4 or 5, **characterized in that** the method steps are carried out one after the other, with the next method step only being carried out if the preceding method step produced a negative result.

8. Apparatus for the on-board diagnosis of a motor-vehicle electrical system while the motor vehicle is being driven, comprising a device for detecting and evaluating the voltage of the vehicle electrical system,
**characterized in that**
the ripple of the voltage of the vehicle electrical system can be determined by means of the device, and the device has an associated fan which can be switched on as a function of the diagnosis of the vehicle electrical system.

9. Apparatus according to Claim 8, **characterized in that** the fluctuation range of the voltage of the vehicle electrical system can be detected.

10. Apparatus according to Claim 9, **characterized in that** the fluctuation range of the voltage of the vehicle electrical system, the gradient from the mean value of the deviation and/or an absolute offset of the low-pass-filtered voltage of the vehicle electrical system can be determined and can be combined in the device to produce a result.

11. Apparatus according to Claim 8, **characterized in that** the number of times the voltages of the vehicle electrical system exceed and/or fall below an associated upper and lower limit value per unit time can be detected.

## Revendications

1. Procédé pour réaliser le diagnostic embarqué du réseau de bord d'un véhicule automobile pendant le déplacement du véhicule automobile, la tension du réseau de bord étant acquise et interprétée, **caractérisé en ce que** l'ondulation de la tension du réseau de bord est acquise, un ventilateur étant mis en marche en cas de détection d'une situation critique du réseau de bord, lequel en cas de chute de tension, réinjecte dans le réseau de bord par effet générateur l'énergie accumulée mécaniquement.

2. Procédé selon la revendication 1, **caractérisé en ce que** la tension du réseau de bord se voit attribuer une valeur limite supérieure et inférieure (Uₒ, Uᵤ) et le nombre de franchissement de la valeur supérieure et/ou inférieure par unité de temps est déterminé.

3. Procédé selon la revendication 1, **caractérisé en ce que** l'on détecte une largeur de fluctuation absolue ou relative de la tension du réseau de bord.

4. Procédé selon la revendication 2 ou 3, **caractérisé en ce que** le gradient de la valeur moyenne de l'écart est détecté.

5. Procédé selon l'une des revendications .2 à 4, **caractérisé en ce que** la tension du réseau de bord est soumise à un filtrage passe-bas et le décalage par rapport à une tension de réseau de bord intacte est déterminé.

6. Procédé selon la revendication 4 ou 5, **caractérisé en ce que** les étapes du procédé sont exécutées en parallèle et les résultats individuels sont regroupés par pondération.

7. Procédé selon la revendication 4 ou 5, **caractérisé en ce que** les étapes du procédé sont exécutées les unes après les autres, l'étape suivante du procédé n'étant exécutée que si l'étape précédente du procédé était négative.

8. Dispositif pour réaliser le diagnostic embarqué du réseau de bord d'un véhicule automobile pendant le déplacement du véhicule automobile, comprenant un dispositif pour acquérir et interpréter la tension du réseau de bord, **caractérisé en ce que** l'ondulation de la tension du réseau de bord peut être déterminée par le biais du dispositif et un ventilateur pouvant être activé en fonction du diagnostic du réseau de bord est associé au dispositif.

9. Dispositif selon la revendication 8, **caractérisé en ce que** la largeur de fluctuation de la tension du réseau de bord peut être détectée.

10. Dispositif selon la revendication 9, **caractérisé en ce que** la largeur de fluctuation de la tension du réseau de bord, le gradient de la valeur moyenne de l'écart et/ou un décalage absolu de la tension du réseau de bord soumise à un filtrage passe-bas peuvent être déterminés et peuvent être regroupés dans le dispositif pour former un résultat.

11. Dispositif selon la revendication 8, **caractérisé en ce que** le nombre de fois où la tension du réseau de bord franchit une valeur limite supérieure et inférieure par unité de temps associable peut être détecté.
